**Europäisches Patentamt**

**European Patent Office**

**Office européen des brevets**

(11) Veröffentlichungsnummer: **0 119 401**
A2

# (12) EUROPÄISCHE PATENTANMELDUNG

(21) Anmeldenummer: 84100620.8

(22) Anmeldetag: 20.01.84

(51) Int. Cl.³: **B 65 H 7/14,** H 03 K 17/94, G 01 V 9/04

(30) Priorität: 18.02.83 DE 3305606

(43) Veröffentlichungstag der Anmeldung: 26.09.84
Patentblatt 84/39

(84) Benannte Vertragsstaaten: **AT CH FR IT LI NL SE**

(71) Anmelder: **Heidelberger Druckmaschinen Aktiengesellschaft,
Kurfürsten-Anlage 52-60 Postfach 10 29 40,
D-6900 Heidelberg 1 (DE)**

(72) Erfinder: **Rodl, Anton, Karlsruherstrasse 12,
D-6906 Leimen (DE)**
Erfinder: **Blasius, Udo, Eschenweg 7, D-6906 Leimen
(DE)**

(74) Vertreter: **Stoltenberg, Baldo Heinz-Herbert, c/o
Heidelberger Druckmaschinen AG
Kurfürsten-Anlage 52-60, D-6900 Heidelberg 1 (DE)**

(54) Schaltungsanordnung für Lichtschranken, z.B. für eine Bogenkontrollvorrichtung bei Druckmaschinen.

(57) Eine Schaltungsanordnung für eine opto-elektronische Bogenkontrollvorrichtung besteht darin, daß sie Signale von Fehl-, Schräg-, Früh- und/oder Mehrfachbogen bei Druckmaschinen erfaßt und weiterverarbeitet. Die erfaßten Signale der Fehl-, Schräg-, Früh- und/oder Mehrfachbogen werden über ein digitales Filter einer Auswerteeinrichtung zugeführt. Diese Auswerteeinrichtung leitet die zu erfolgenden Operationen an der Druckmaschine ein.

EP 0 119 401 A2

Die Erfindung bezieht sich auf eine Schaltungsanordnung für Lichtschranken, z.B. für eine optoelektronische Bogenkontrollvorrichtung, bei der die Signale von Fehl- Schräg-, Früh- und/oder Mehrfachbogen bei Druckmaschinen von einer Sende- und Empfangseinrichtung erfaßt und von einer Auswerteeinrichtung weiterverarbeitet und zur Ableitung von Folgeoperationen der Druckmaschinen zugeführt werden.

Bekannt sind analoge Auswerteeinrichtungen für Signale. Die Offenlegungsschrift DE-OS 29 01 229 A1 beschreibt eine kapazitive Kontroll- und Auswerteeinrichtung an Druckmaschinen zur Kontrolle von Fehl- und/oder Mehrfachbogen.

Einer mit einem Pulsgenerator verbundenen Vergleichsschaltung sind eine Komparatorschaltung, eine Phasenauswertung und Auswerteschaltungen für Fehl-und Mehrfachbogen nachgeordnet.

Die Vergleichsschaltung besteht aus einem RC-Glied mit einem Meßkondensator und einem weiteren RC-Glied mit einem Vergleichskondensator. Der Pulsgenerator, zur Erzeugung der Pulsspannung, ist über ein Potentiometer zur Einstellung auf Fehl- und/oder Mehrfachbogen mit den RC-Gliedern verbunden. Aus einem Operationsverstärker besteht die Komparatorschaltung, und zur Phasenauswertung werden Und-Gatter verwendet. Für die Auswerteschaltung findet ein Verstärker Anwendung.

Die Kontrolle über Fehl- und/oder Mehrfachbogen wird dabei über hervorgerufene Kapazitätsänderungen an dem Meßkondensator der Vergleichsschaltung durchgeführt. Mittels einer Signalverarbeitung werden die Kapazitätsänderungen erfaßt und zur Ableitung von Folgeoperationen der Druckmaschine zugeführt. Durch Vergleich der Signallaufzeiten einer Pulsspannung über ein Integrierglied mit dem Meßkondensator und über ein Vergleichs- RC- Glied wird dies realisiert.

Nachteilig bei diesen kapazitiven Meß- und Kontrolleinrichtungen ist, daß der Genauigkeitsgrad noch nicht ausreichend ist, um jegliche Fehl- und/oder Mehrfachbogen an Druckmaschinen zu erkennen. Zudem bewirken überlagernde Signale Fehlmessungen und führen zu Störungen im Ablauf des Druckprozesses. Ferner erweist sich dieses Meß- und Kontrollverfahren durch die sehr langen Integrationszeiten als nachteilig.

Aufgabe der Erfindung ist es, die von z.B. Reflexlichtschranken gelieferten Signale von überlagerten Störungen zu befreien, um nur die echten, d.h. die gewünschten Informationen sehr schnell zu erhalten und an die nachfolgende Elektronik weiterzuleiten und dadurch die Stillstandzeiten und den Makulaturanfall bei Druckmaschinen zu verringern.

Erfindungsgemäß wird dies ausgeführt, indem die Sende- und Empfangseinrichtung als Reflexlichtschranke ausgebildet ist, und daß zwischen dieser und der Auswerteeinrichtung ein digitales Filter geschaltet ist, für das zwei parallelgeschaltete bistabile Kippschaltungen vorgesehen sind, von denen eine einen negierten Takteingang aufweist.
Vorteilhafterweise ist den beiden Ausgängen der bistabilen Kippschaltungen des digitalen Filters wenigstens eine Konjunktion nachgeschaltet.

Eine weiterere Ausgestaltung der Erfindung besteht darin, daß mindestens ein Eingang der nachgeschalteten Konjunktion des digitalen Filters zeitgepulst wird und dem Ausgang der Konjunktion ein Zeitglied nachgeschaltet ist, ferner ist der Ausgang des Zeitgliedes mit der Auswerteelektronik und mit den Rücksetzeingängen der beiden bistabilen Kippschaltungen verbunden.

Die Auswerteelektronik ermöglicht somit eine wesentlich schnellere Signalauswertung als die herkömmlichen Signalauswertungsvorrichtungen. Durch die erfindungsmäßige Vorrichtung wird eine Ausfilterung von Fehlsignalen, die durch Störungen hervorgerufen werden, vorgenommen, d.h. es werden nur die wichtigen und notwendigen Informationen herauskristallisiert und somit ein ungestörter Ablauf des Druckprozesses gewährleistet.

Eine Ausführung der Erfindung wird im folgenden anhand der Zeichnungen erläutert.
Es zeigen:

Figur 1     ein Blockschaltbild einer optischen Überwachungseinrichtung mit digitalem Filter,
Figur 2     den Stromlaufplan eines digitalen Filters und
Figur 3     ein Impulsdiagramm der Ein- und Ausgangssignale eines digitalen Filters.

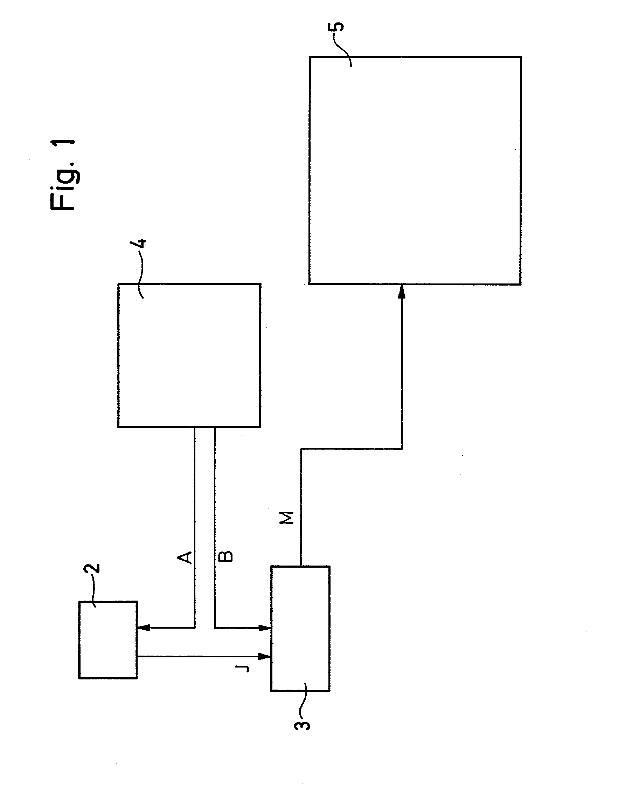

In Figur 1 ist ein optische Überwachungseinrichtung im Blockschaltbild dargestellt. Diese Überwachungseinrichtung besteht aus einem Reflextaster 2, einer nicht näher dargestellten Schaltung 4 zur Erzeugung des Sendestromimpulses A für den Reflextaster 2 und des Steuersignales B für das digitale Filter 3. Dem digitalen Filter 3 ist eine nicht näher dargestellte Auswerteeinheit 5 nachgeschaltet.

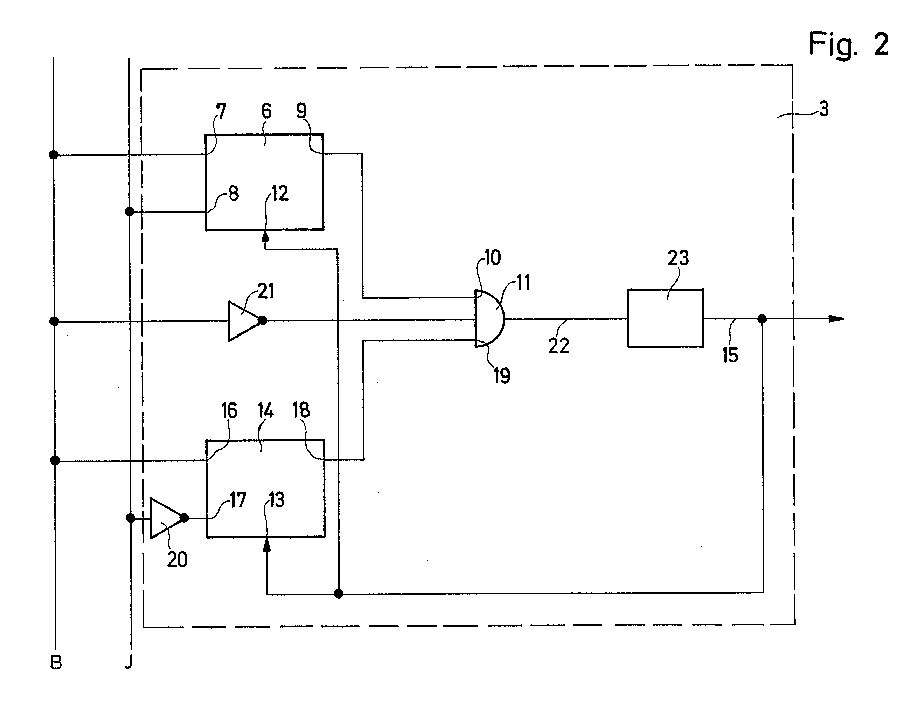

In Figur 2 ist der Stromlaufplan des digitalen Filters 3 abgebildet. Das Ausgangssignal J des Reflextasters 2 wird an den Takteingang 8 eines ersten D-Flip-Flops 6 angelegt. Das durch das Negationsglied 20 negierte Ausgangssignal J wird an den Takteingang 17 eines zweiten D-Flip-Flops 14 angelegt. Der Dateneingang 7 des D-Flip-Flops 6 und der Dateneingang 16 des D-Flip-Flops 14 sind mit dem in der Schaltung erzeugten Ausgangssignal B verbunden. Die Q-Ausgänge 9 und 18 sowie das durch ein Negationsglied 21 negierte Signal B, $\bar{B}$ werden über ein Und-Gatter 11 verknüpft. Das Ausgangssignal 22 des Und-Gatters 11 triggert das nachgeschaltete Monoflop 23, dessen Ausgangspuls 15 an die Auswerteeinheit 5 sowie an die Rücksetz-Eingänge 12 und 13 der D-Flip-Flops 6 und 14 angelegt wird.

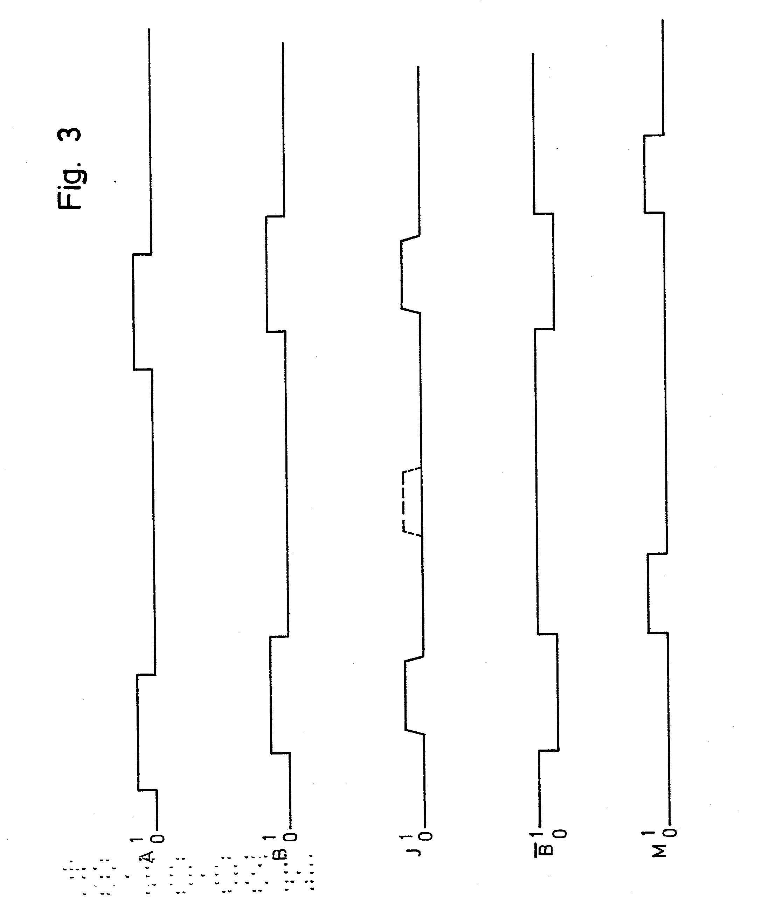

In Figur 3 ist ein Impulsdiagramm dargestellt, das den Ablauf und die Signalpegel A, B, J, $\bar{B}$, M während der Funktion zeigt. Im folgenden wird die Funktionsweise des digitalen Filters 3 beschrieben. Die Sendestromimpulse A werden mit einer vorgegebenen Frequenz, beispielsweise 10 KHz an den Reflextaster 2 angelegt. Je nachdem, ob der Reflextaster 2 ein Objekt erkennt oder nicht, gibt dieser ein Ausgangssignal J gleicher Frequenz und gleicher Pulsbreite ab. Die Ausgangssignale J sind jedoch gegenüber den Sendestromimpulsen A verformt. Der Pulsanfang und das Pulsende des Ausgangssignales J sind um einen bestimmten Betrag gegenüber denen des Sendestromimpulses A verschoben. Ein Impuls B wird dadurch um mindestens diesen Betrag gegenüber dem Sendestromimpuls A verzögert erzeugt.

Wird vom Reflextaster 2 ein Ausgangssignal J abgegeben, bewirkt dessen ansteigende Flanke am Takteingang 8 des D-Flip-Flops 6 die Übernahme der Information B am Dateneingang 7 des D-Flip-Flops 6 zu dessen Q-Ausgang 9 und speichert diese Information ab. Die abfallende Flanke des Ausgangssignales J am Takteingang 17 des D-Flip-Flops 14 bewirkt die Übernahme der Information B am Dateneingang 16 des D-Flip-Flops 14 zu dessen Q-Ausgang 18 und speichert diese Information ab. Am Q-Ausgang 9 des D-Flip-Flops 6 und am Q-Ausgang 18 des D-Flip-Flops 14 kann also nur dann der logische Ausgangspegel "1" anliegen, wenn zum Zeitpunkt der ansteigenden Flanke bzw. der abfallenden Flanke des Ausgangssignales J der logische Signalpegel der Information B ebenfalls auf "1" war. Die Ausgangssignale der beiden Q-Ausgänge 9 und 18 der D-Flip-Flops 6 und 14 werden zusätzlich über das Und-Glied 11 mit dem negierten Signal B, $\overline{B}$ verknüpft. Das Ausgangssignal 22 dieses Und-Gliedes 11 hat daher nur dann den logischen Signalpegel "1", wenn die Information B logisch "0" ist und die Q-Ausgänge 9 und 18 der D-Flip-Flops 6 und 14 den logischen Signalpegel "1" aufweisen. Der nachgeschaltete Monoflop 23 wird mit der positiven Flanke des Ausgangssignals 22 getriggert. Der Ausgangspuls 15 des Monoflops 23 wird auf eine Zeit festgelegt, die abhängig ist von der Taktfrequenz des Sendestromimpulses A und der Auslegung der nachfolgenden Auswerteschaltung 5. Gleichzeitig wird mit dem Ausgangspuls 15 des Monoflops 23 die Speicherung der D-Flip-Flops 6 und 14 zurückgenommen.

Das digitale Filter 3 wird somit als Ausblendschaltung oder Sicherheitsschaltung für Reflexlichtschranken bezeichnet und dient dazu, ein sauberes entstörtes Signal zu bekommen.

-5-

## TEILELISTE

| | |
|---|---|
| 2 | Reflextaster |
| 3 | Digitales Filter |
| 4 | Schaltung |
| 5 | Auswerteeinheit |
| 6 | D-Flip-Flop |
| 7 | Dateneingang |
| 8 | Takteingang |
| 9 | Q-Ausgang |
| 10 | Eingang des Und-Gatters |
| 11 | Und-Gatter |
| 12 | Rücksetzeingang |
| 13 | Rücksetzeingang |
| 14 | D-Flip-Flop |
| 15 | Ausgangspuls |
| 16 | Dateneingang |
| 17 | Takteingang |
| 18 | Q-Ausgang |
| 19 | Eingang des Und-Gatters |
| 20 | Negationsglied |
| 21 | Negationsglied |
| 22 | Ausgangssignal |
| 23 | Monoflop |

## ANSPRÜCHE

1. Schaltungsanordnung für Lichtschranken, z.B. für eine optoelektronische Bogenkontrollvorrichtung, bei der die Signale von Fehl-, Schräg-, Früh- und/oder Mehrfachbogen bei Druckmaschinen von einer Sende- und Empfangseinrichtung erfaßt und von einer Auswerteeinrichtung weiterverarbeitet und zur Ableitung von Folgeoperationen der Druckmaschine zugeführt werden,
**dadurch gekennzeichnet,**
daß die Sende-und Empfangseinrichtung als Reflexlichtschranke (2) ausgebildet ist, und daß zwischen dieser und der Auswerteeinrichtung (5) ein digitales Filter (3) geschaltet ist, für das zwei parallelgeschaltete bistabile Kippschaltungen (6, 14) vorgesehen sind, von denen eine einen negierten Takteingang aufweist.

2. Schaltungsanordnung für Lichtschranken nach Anspruch 1,
**dadurch gekennzeichnet,**
daß beiden Ausgängen der bistabilen Kippschaltungen (6, 14) des digitalen Filters (3) wenigstens eine Konjunktion (11) nachgeschaltet ist.

3. Schaltungsanordnung für Lichtschranken nach einem der vorhergehenden Ansprüche,
**dadurch gekennzeichnet,**
daß mindestens ein Eingang der nachgeschalteten Konjunktion (11) des digitalen Filters (3) zeitgepulst wird und dem Ausgang der Konjunktion (11) ein Zeitglied (23) nachgeschaltet ist.

4. Schaltungsanordnung für Lichtschranken nach einem der vorhergehenden Ansprüche,
**dadurch gekennzeichnet,**
daß der Ausgang des Zeitgliedes (23) mit der Auswerteelektronik (5) und mit den Rücksetzeingängen der beiden bistabilen Kippschaltungen (6, 14) verbunden ist.

Fig. 1

0119401

Fig. 2

2/3

0119401

Fig. 3

3/3

011940 1